# EUROPEAN PATENT APPLICATION

(11) **EP 4 167 274 A1**
(43) Date of publication of application: **19.04.2023**
(21) Application number: 21826566.8
(22) Date of filing: 23.03.2021
(51) Int. Cl.: H01L 21/60

(54) **SEMICONDUCTOR DEVICE AND METHOD FOR PRODUCING SAME**

(30) Priority: 15.06.2020 JP 2020102804
(71) Applicant: Sony Semiconductor Solutions Corporation, Atsugi-shi Kanagawa 243-0014 (JP)
(72) Inventor: TSUJI, Mutsuo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/011982
(87) International publication number: WO 2021/256040

(57) **Abstract**

When a semiconductor element and a wiring board are connected to each other, connection at a minute pitch is performed while securing reliability.

In a semiconductor device, a semiconductor element and a wiring board are connected to each other. A bump is formed on an electrode in either the semiconductor element or the wiring board. This bump contains metal nanoparticles as a component. The bump may be formed by sintering the metal nanoparticles that are applied. Furthermore, the metal nanoparticles may be applied and sintered a plurality of times to form a plurality of layers. A connection between the semiconductor element and the wiring board may be formed by sintering the other metal nanoparticles that are applied.

## Description

### TECHNICAL FIELD

The present technology relates to a technology of mounting a semiconductor element. Specifically, this relates to a technology of flip-chip mounting the semiconductor element on a wiring board.

### BACKGROUND ART

As a technology of connecting a semiconductor element to a wiring board, a technology referred to as controlled collapse chip connection (C4) in which a bump is formed by solder plating, molten by reflow, and connected has been developed in the 1960's (refer to, for example, Non-Patent Document 1). Moreover, this is developed in the 1980's, and there is copper pillar connection in which a bump is formed with copper plating and is solder-plated in order to implement narrow-pitch connection. However, since this C4 method forms the bump by plating, a complicated process is required, and since a wafer is exposed to a plating solution and the like, the wafer might be damaged and contaminated. Furthermore, since the bump for connection is formed by using solder, in a case where a package formed by this method is secondarily mounted on a device and the like, it is necessary to use low-temperature solder having low reliability for secondary mounting in order to avoid remelting of the solder of the connection, or to form the bump with high-temperature solder and connect at high temperature, thereby exposing the semiconductor element and a connection board at high temperature. Therefore, a problem in reliability might occur.

Therefore, as another technology of connecting the semiconductor element to the wiring board, there is a stud bump bonding (SBB) technology of connecting using a stud bump and a conductive resin (refer to, for example, Non-Patent Document 2). According to this SBB technology, connection may be performed at about 150°C to 200°C, and remelting does occur at the time of secondary mounting.

### CITATION LIST

### NON-PATENT DOCUMENT

Non-Patent Document 1: Toshio KATO, "Current state of flip-chip mounting technology and future problems", Journal of Japan Institute of Electronics Packaging, Vol. 2, No. 5, 1999
Non-Patent Document 2: Koichi KUMAGAI et al., "SBB micro bonding technology", Journal of Japan Institute for Interconnecting and Packaging Electronic Circuits, Vol. 10, No. 6, 1995

### SUMMARY OF THE INVENTION

### PROBLEMS TO BE SOLVED BY THE INVENTION

In the above-described SBB technology, remelting at the time of secondary mounting may be avoided. However, in this SBB technology, since a stud bump is formed using a wire bonding technology and a conductive resin is transferred to a tip end of the stud bump, this may cope with only a pitch of about 80 µm. Furthermore, since it is connected using a conductive resin, there is a problem that a connection resistance is high and reliability of the connection is low.

The present technology has been made in view of such a situation, and an object thereof is to perform connection at a minute pitch while securing reliability when connecting a semiconductor element to a wiring board.

### SOLUTIONS TO PROBLEMS

The present technology has been made to solve the above-described problems, and a first aspect thereof is a semiconductor device including an electrode, and a bump containing metal nanoparticles as a component, the bump formed on the electrode, and a method of manufacturing the same. This brings about an effect of forming the bump containing the metal nanoparticles as the component on the electrode.

Furthermore, in the first aspect, the electrode may be an electrode of a semiconductor element, or may be an electrode of a wiring board.

Furthermore, in the first aspect, the bump may be formed by sintering the metal nanoparticles that are applied.

Furthermore, in the first aspect, the bump may include a plurality of layers formed by repeatedly applying and sintering the metal nanoparticles a plurality of times. This brings about an effect of flexibly setting a shape of the bump. In this case, in the bump, the plurality of layers may be equal in size, and adjacent layers out of the plurality of layers may have different sizes. For example, the bump may have a barrel shape or a drum shape as an entire shape including the plurality of layers.

Furthermore, in the first aspect, the bump may contain at least one type of element of gold, silver, copper, or palladium as the metal nanoparticles. Furthermore, the bump may be a mixture of metal microparticles containing at least one type of element of gold, silver, copper, or palladium and the metal nanoparticles.

Furthermore, in the first aspect, the bump may include a plurality of bumps having different sizes. For example, it is possible to set the size of the bump to be larger than that of a normal signal line for one in which it is desired to reduce a resistance value such as power supply and ground.

Furthermore, in the first aspect, a connection containing other metal nanoparticles as a component, the connection formed between the bump and another electrode may be further included. This brings about an effect of electrically connecting the bump and another electrode. In this case, the connection may be formed by sintering the other metal nanoparticles that are applied. Furthermore, the metal nanoparticles and the other metal nanoparticles may contain the same type of element or contain different types of elements.

Furthermore, in the first aspect, the electrode may be an electrode of a semiconductor element, the another electrode may be an electrode of a wiring board, the semiconductor device may include the semiconductor element and the wiring board. This brings about an effect that the semiconductor device is formed by the semiconductor element and the wiring board electrically connected to each other via the connection.

### BRIEF DESCRIPTION OF DRAWINGS

Fig. 1 is a diagram illustrating an example of a cross-sectional structure of a semiconductor device in a first embodiment of the present technology.
Fig. 2 is a diagram illustrating a first half of an example of a manufacturing process of the semiconductor device in the first embodiment of the present technology.
Fig. 3 is a diagram illustrating a second half of an example of a manufacturing process of the semiconductor device in the first embodiment of the present technology.
Fig. 4 is a diagram illustrating an example of a cross-sectional structure of a semiconductor device in a first variation of the first embodiment of the present technology.
Fig. 5 is a diagram illustrating an example of a cross-sectional structure of a semiconductor device in a second variation of the first embodiment of the present technology.
Fig. 6 is a diagram illustrating an example of a cross-sectional structure of a semiconductor device in a second embodiment of the present technology.
Fig. 7 is a diagram illustrating an example of a manufacturing process of the semiconductor device in the second embodiment of the present technology.
Fig. 8 is a diagram illustrating an example of a cross-sectional structure of a semiconductor device in a third embodiment of the present technology.
Fig. 9 is a diagram illustrating an example of a cross-sectional structure of a bump 120 in a fourth embodiment of the present technology.
Fig. 10 is a diagram illustrating an example of a cross-sectional structure of a semiconductor device in a fifth embodiment of the present technology.

### MODE FOR CARRYING OUT THE INVENTION

Modes for carrying out the present technology (hereinafter, referred to as embodiments) are hereinafter described. The description is given in the following order.
1. First Embodiment (Example of Providing Bump Using Metal Nanoparticles on Semiconductor Element)
2. Second Embodiment (Example of Making Multi-layered Bump)
3. Third Embodiment (Example of Using Bumps of Different Sizes)
4. Fourth Embodiment (Example of Changing Size of Respective Layers of Bump)
5. Fifth Embodiment (Example of Providing Bump Using Metal Nanoparticles on Wiring Board)

### <1. First Embodiment>

### [Structure of Semiconductor Device]

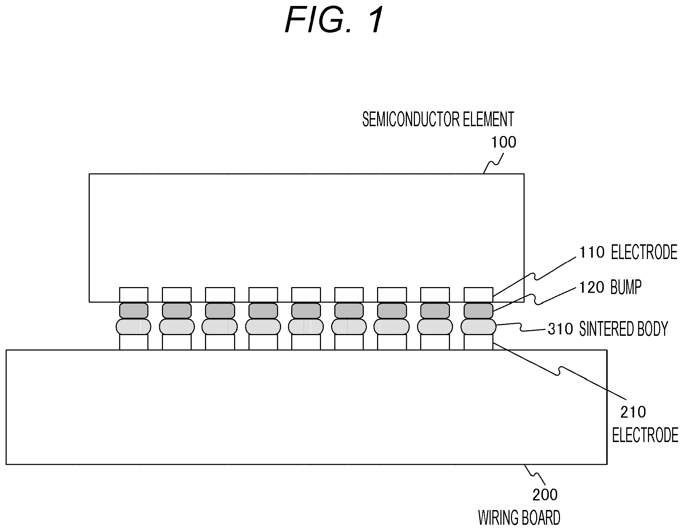

Fig. 1 is a diagram illustrating an example of a cross-sectional structure of a semiconductor device in a first embodiment of the present technology.

The semiconductor device is obtained by mounting a semiconductor element 100 on a wiring board 200. In this embodiment, flip-chip mounting is assumed as a technology of mounting the semiconductor element 100 on the wiring board 200.

The semiconductor element 100 is a semiconductor chip containing a semiconductor material. The semiconductor element 100 is provided with an electrode 110 for an input/output signal to/from outside, power supply, ground (GND) and the like on a surface facing the wiring board 200.

A bump 120 is formed on the electrode 110 of the semiconductor element 100. The bump 120 is formed by drawing and sintering first metal nanoparticles. The first metal nanoparticles are particles obtained by finely dividing metal of an element such as silver (Ag), gold (Au), copper (Cu), and palladium (Pd) into nanosize, and usually form a paste-like material mixed with a solvent. By baking the first metal nanoparticles at about 100°C to 250°C, the nanoparticles are bonded to each other to form a metal sintered body.

There is a case where the first metal nanoparticles include a single type of metal and a mixture of a plurality of types. Furthermore, metal microparticles may be mixed. Since a particle size of the metal microparticle is larger than that of the metal nanoparticle, an interface decreases, and a resistance value lowers as a whole. A type of a metal element of the metal microparticle in this case is similar to that of the metal nanoparticle.

The wiring board 200 is an insulator substrate provided with conductor wiring that electrically connects chips. The wiring board 200 is provided with an electrode 210 corresponding to the electrode 110 of the semiconductor element 100.

The bump 120 of the semiconductor element 100 and the electrode 210 of the wiring board 200 are connected to each other via a sintered body 310. The sintered body 310 is formed by sintering second metal nanoparticles. Similar to the first metal nanoparticles, the second metal nanoparticles are particles obtained by finely dividing metal into nanosize. Note that, the sintered body 310 is an example of a connection recited in claims.

The first metal nanoparticle and the second metal nanoparticle may be the same or different from each other. It is possible to select according to a property; for example, one suitable for bump formation, one suitable for connection and the like.

By using the first and second metal nanoparticles, an apparent melting point lowers, so that a heat influence on the semiconductor element may be suppressed, and reliability may be improved.

### [Manufacturing Process of Semiconductor Device]

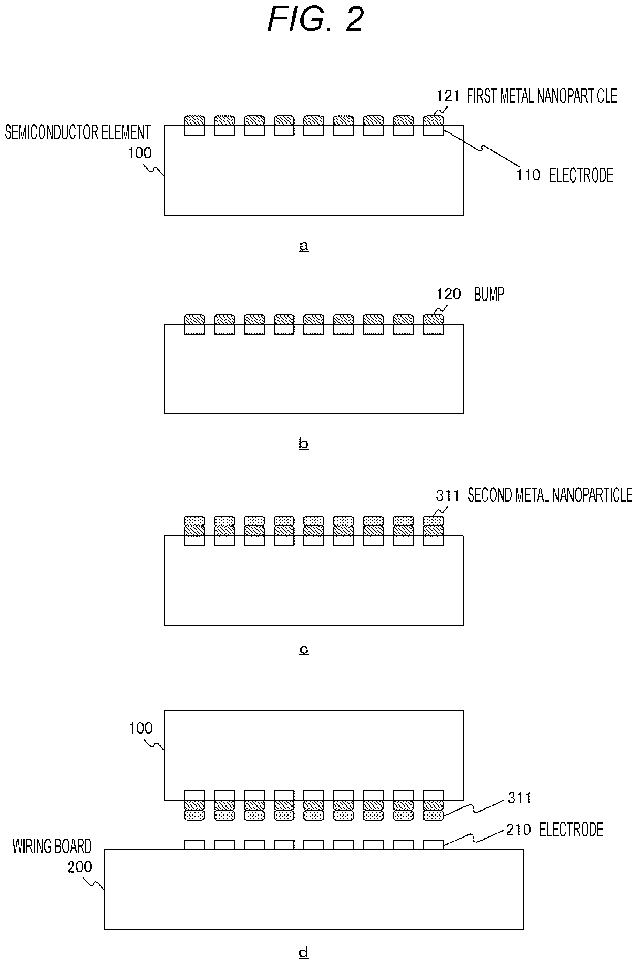

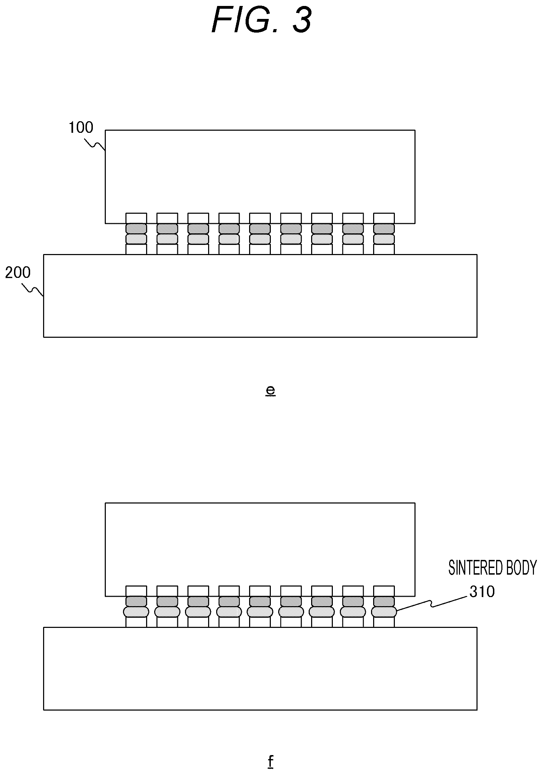

Figs. 2 and 3 are diagrams illustrating an example of a manufacturing process of the semiconductor device in the first embodiment of the present technology.

First, as illustrated in a of the drawing, first metal nanoparticles 121 are applied to the electrode 110 of the semiconductor element 100 by about 5 to 50 µm. Examples of an applying method in this case include printing, dispensing, inkjet, aerosol jet, LIFT and the like. They may be selected according to an applied material, an applied amount, and a pitch.

Next, as illustrated in b of the drawing, the applied first metal nanoparticles 121 are sintered to form the bump 120 having a height of 5 to 100 µm. As a sintering method, heating at 70°C to 250°C is common, but sintering by laser irradiation and sintering by light irradiation with a xenon lamp and the like may be used.

Then, as illustrated in c of the drawing, second metal nanoparticles 311 are applied onto the bump 120 by about 5 to 50 µm. An applying method of the second metal nanoparticles 311 is similar to that in a case of the first metal nanoparticles 121 described above.

Thereafter, as illustrated in d of the drawing, alignment of the second metal nanoparticles 311 applied to the bump 120 of the semiconductor element 100 with the electrode 210 of the wiring board 200 is performed. Then, as illustrated in e of the drawing, the semiconductor element 100 and the wiring board 200 are bonded together, and heated at 70°C to 250°C to sinter the second metal nanoparticles 311. Therefore, as illustrated in f of the drawing, the sintered body 310 is formed between the semiconductor element 100 and the wiring board 200, and both are electrically connected to each other and the semiconductor device is manufactured.

Note that, in this example, the bump 120 is formed by applying the first metal nanoparticles 121 to an individual semiconductor element 100, but the bump 120 may be formed in a wafer state.

In this manner, in the first embodiment of the present technology, the bump 120 obtained by sintering the first metal nanoparticles 121 is formed on the electrode 110 of the semiconductor element 100, and this is connected to the electrode 210 of the wiring board 200 by the sintered body 310 obtained by sintering the second metal nanoparticles 311. This makes it possible to obtain a connection characteristic with low connection resistance and high connection strength. Furthermore, remelting does not occur by reflow at the time of subsequent mounting on the device, so that high reliability may be obtained. Furthermore, a wet process as in a plating process is not required, and damage and contamination to the semiconductor element 100 may be avoided.

### [First Variation]

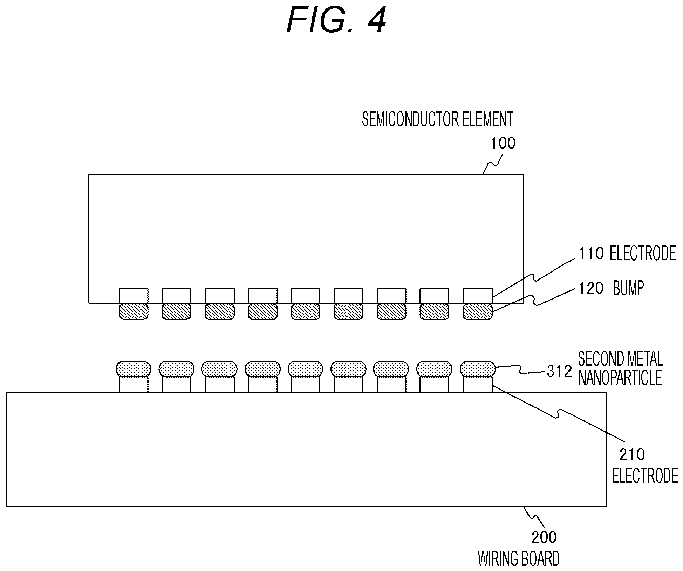

Fig. 4 is a diagram illustrating an example of a cross-sectional structure of a semiconductor device in a first variation of the first embodiment of the present technology.

In the first embodiment described above, the second metal nanoparticles 311 are applied onto the bump 120 of the semiconductor element 100, but in this first variation, second metal nanoparticles 312 are applied onto an electrode 210 of a wiring board 200. A processing procedure after sintering after alignment is similar to that in the first embodiment described above.

### [Second Variation]

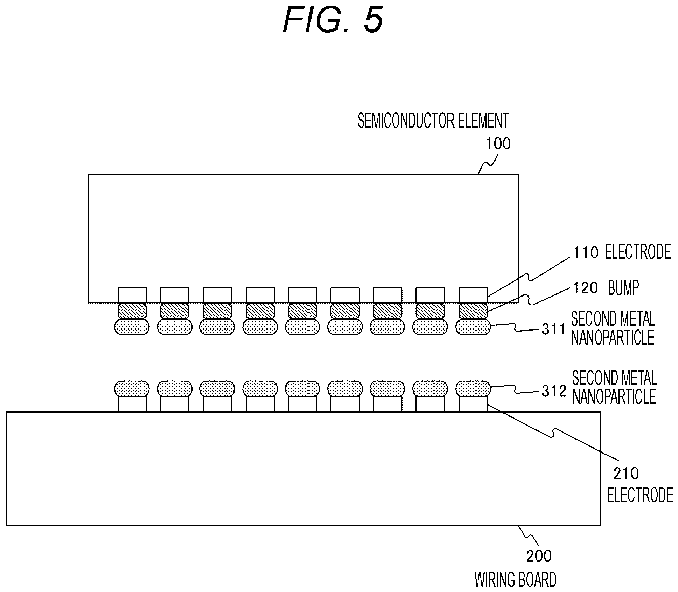

Fig. 5 is a diagram illustrating an example of a cross-sectional structure of a semiconductor device in a second variation of the first embodiment of the present technology.

In the first embodiment described above, the second metal nanoparticles 311 are applied onto the bump 120 of the semiconductor element 100, but in this second variation, in addition to this, second metal nanoparticles 312 are further applied onto an electrode 210 of a wiring board 200. A processing procedure after sintering after alignment is similar to that in the first embodiment described above.

### <2. Second Embodiment>

### [Structure of Semiconductor Device]

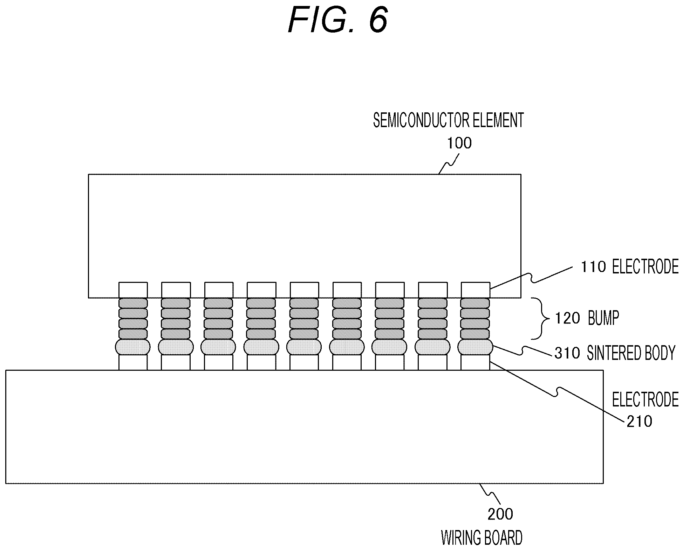

Fig. 6 is a diagram illustrating an example of a cross-sectional structure of a semiconductor device in a second embodiment of the present technology.

In the first embodiment described above, it is assumed that the bump 120 is of a single layer, but in the second embodiment, it is assumed that a plurality of layers is formed by repeatedly applying and sintering first metal nanoparticles 121 a plurality of times. Therefore, it is possible to form a bump higher in height or a smaller bump capable of coping with a minute pitch.

### [Manufacturing Process of Semiconductor Device]

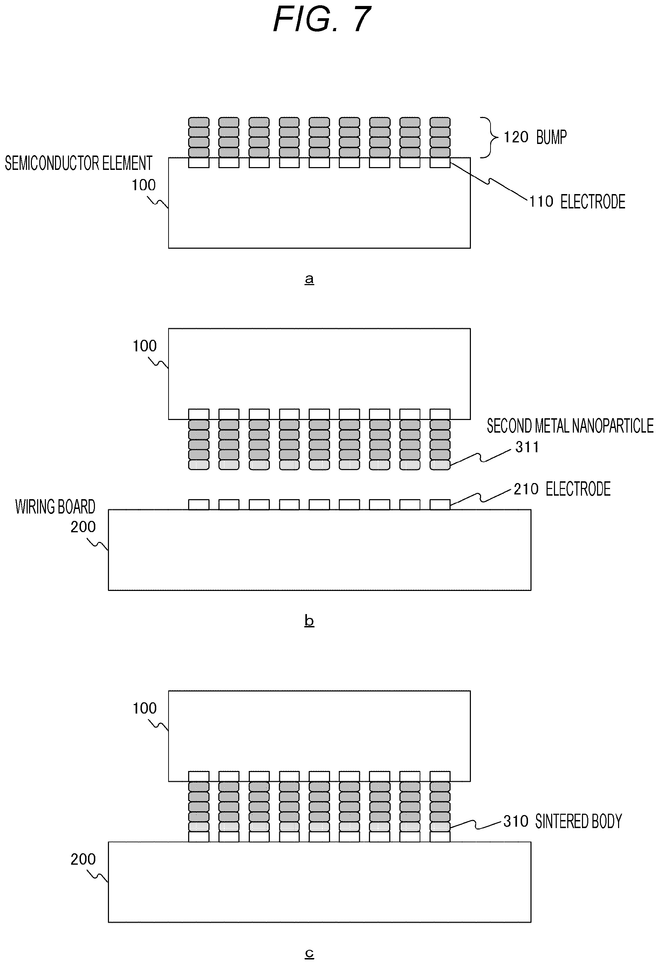

Fig. 7 is a diagram illustrating an example of a manufacturing process of the semiconductor device in the second embodiment of the present technology.

As illustrated in a of the drawing, by repeating a process of applying the first metal nanoparticles 121 to an electrode 110 of a semiconductor element 100 and sintering the same, a bump 120 including a plurality of layers is formed.

Then, as illustrated in b of the drawing, second metal nanoparticles 311 are applied onto the bump 120 and alignment with an electrode 210 of a wiring board 200 is performed.

Thereafter, as illustrated in c of the drawing, the semiconductor element 100 and the wiring board 200 are bonded together to be heated, so that the second metal nanoparticles 311 are sintered, and a sintered body 310 is formed between the semiconductor element 100 and the wiring board 200. Therefore, the semiconductor element 100 and the wiring board 200 are electrically connected to each other, and the semiconductor device is manufactured.

In this manner, in the second embodiment of the present technology, by repeatedly applying and sintering the first metal nanoparticles 121 a plurality of times, a plurality of layers is formed. Therefore, the height and size of the bump 120 may be flexibly set.

### <3. Third Embodiment>

### [Structure of Semiconductor Device]

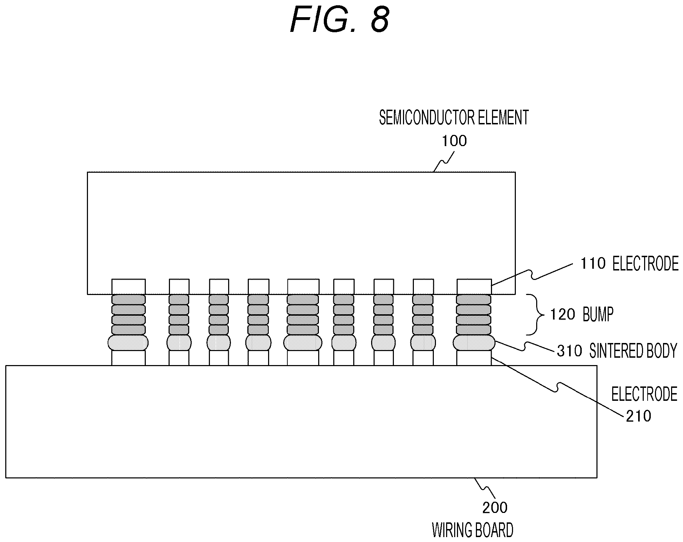

Fig. 8 is a diagram illustrating an example of a cross-sectional structure of a semiconductor device in a third embodiment of the present technology.

In the first embodiment described above, it is assumed that the sizes of the bumps 120 are equal, but in the third embodiment, it is assumed that sizes of bumps 120 are appropriately set to different sizes.

In this third embodiment, the size of the bump 120 to be formed is set by adjusting an amount and an area of first metal nanoparticles 121 to be applied onto an electrode 110 of a semiconductor element 100. In a case of using plating as in C4, it is necessary to collectively prepare a mask, but in this embodiment, a procedure of applying the metal nanoparticles may be controlled by, for example, a program, so that it is possible to easily cope with small-quantity and multi-product production.

In this case, for example, it is conceivable to set the size of the bump 120 to be larger than that of a normal signal line for one in which it is desired to reduce a resistance value such as power supply and ground.

In this manner, according to the third embodiment of the present technology, the size of the bump 120 to be formed may be set as required by adjusting the first metal nanoparticles 121 to be applied.

### <4. Fourth Embodiment>

### [Shape of Bump]

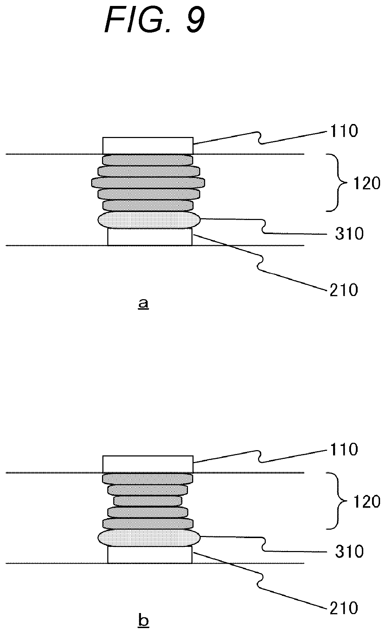

Fig. 9 is a diagram illustrating an example of a cross-sectional structure of a bump 120 in a fourth embodiment of the present technology.

In the second embodiment described above, it is assumed that the sizes of the plurality of layers of the bump 120 are equal, but in this fourth embodiment, it is assumed that sizes of respective layers of the bump 120 are appropriately set to different sizes.

In this fourth embodiment, the size of the bump 120 to be formed is set by adjusting an amount and an area of first metal nanoparticles 121 to be applied onto an electrode 110 of a semiconductor element 100 in each repetition. This may be implemented by a method similar to that in the third embodiment described above.

For example, as illustrated in a of the drawing, by increasing a size of a central layer of the bump 120, a barrel shape may be formed as an entire shape. Furthermore, as illustrated in b of the drawing, by decreasing the size of the central layer of the bump 120, a drum shape may be formed as the entire shape.

In this manner, according to the fourth embodiment of the present technology, the size of the bump 120 to be formed in each layer may be set as required by adjusting the first metal nanoparticles 121 to be applied in each repetition.

### <5. Fifth Embodiment>

### [Structure of Semiconductor Device]

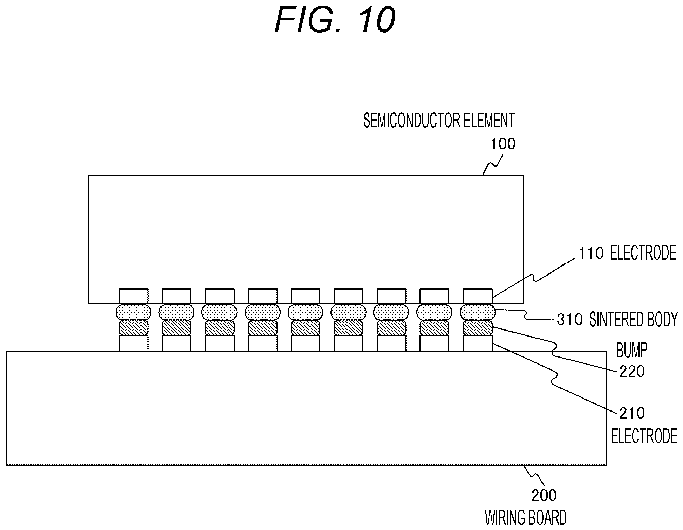

Fig. 10 is a diagram illustrating an example of a cross-sectional structure of a semiconductor device in a fifth embodiment of the present technology.

In the first embodiment described above, it is assumed that the bump 120 is provided on the electrode 110 of the semiconductor element 100, but in this fifth embodiment, it is assumed that a bump 220 is provided on an electrode 210 of a wiring board 200. That is, the bump 120 may be formed on the electrode 110 of the semiconductor element 100 as in the first embodiment described above, and the bump 220 may be formed on the electrode 210 of the wiring board 200 as in this fifth embodiment.

The bump 220 in this fifth embodiment is formed by drawing and sintering first metal nanoparticles similarly to the bump 120 in the other embodiments described above. By applying the first metal nanoparticles onto the electrode 210 of the wiring board 200 and sintering the same, the bump 220 is formed on the electrode 210 of the wiring board 200.

Furthermore, by applying second metal nanoparticles 312 onto the bump 220 and sintering the same after alignment, a sintered body 310 is formed between a semiconductor element 100 and the wiring board 200, and both are electrically connected to each other and the semiconductor device is manufactured.

In this manner, according to each embodiment of the present technology, the first metal nanoparticles 121 are applied and sintered to form the bump 120, and the second metal nanoparticles 311 or 312 are further applied to connect the semiconductor element 100 and the wiring board 200 to each other, so that it is possible to perform connection at a minute pitch by the bump 120 having a minute size. Furthermore, since the metal nanoparticles sintered at low temperature are used, a heat influence on the semiconductor element is small, and reliability may be improved. Since the metal nanoparticles form a metal body when sintered, low resistance connection is possible, and remelting does not occur at the time of secondary mounting, so that high reliability may be secured. Furthermore, a complicated process such as plating or a wet process is not required. Since the size of the bump may also be easily adjusted, the bump size may be adjusted according to power supply and ground, and a required resistance value may be selected.

Note that, the above-described embodiments describe an example of embodying the present technology, and there is a correspondence relationship between items in the embodiments and the matters specifying the invention in claims. Similarly, there is a correspondence relationship between the matters specifying the invention in claims and the matters in the embodiments of the present technology having the same names. However, the present technology is not limited to the embodiments and may be embodied by variously modifying the embodiments without departing from the gist thereof.

Furthermore, the processing procedure described in the above-described embodiments may be considered as a method including a series of procedures and may be considered as a program for allowing a computer to execute the series of procedures, and a recording medium that stores the program. A compact disc (CD), a MiniDisc (MD), a digital versatile disc (DVD), a memory card, a Blu-ray (trademark) disc and the like may be used, for example, as the recording medium.

Note that, the effect described in this specification is illustrative only and is not limitative; there may also be another effect.

Note that, the present technology may also have a following configuration.
(1) A semiconductor device including:
   an electrode; and
   a bump containing metal nanoparticles as a component, the bump formed on the electrode.
(2) The semiconductor device according to (1) described above, in which
   the electrode is an electrode of a semiconductor element.
(3) The semiconductor device according to (1) described above, in which
   the electrode is an electrode of a wiring board.
(4) The semiconductor device according to any one of (1) to (3) described above, in which
   the bump is formed by sintering the metal nanoparticles that are applied.
(5) The semiconductor device according to (4) described above, in which
   the bump includes a plurality of layers formed by repeatedly applying and sintering the metal nanoparticles a plurality of times.
(6) The semiconductor device according to (5) described above, in which
   in the bump, the plurality of layers is equal in size.
(7) The semiconductor device according to (5) described above, in which
   in the bump, adjacent layers out of the plurality of layers have different sizes.
(8) The semiconductor device according to (7) described above, in which
   the bump has a barrel shape as an entire shape including the plurality of layers.
(9) The semiconductor device according to (7) described above, in which
   the bump has a drum shape as an entire shape including the plurality of layers.
(10) The semiconductor device according to any one of (1) to (9) described above, in which
   the bump contains at least one type of element of gold, silver, copper, or palladium as the metal nanoparticles.
(11) The semiconductor device according to any one of (1) to (10) described above, in which
   the bump is a mixture of metal microparticles containing at least one type of element of gold, silver, copper, or palladium and the metal nanoparticles.
(12) The semiconductor device according to any one of (1) to (11) described above, in which
   the bump includes a plurality of bumps having different sizes.
(13) The semiconductor device according to any one of (1) to (12) described above, further including:
   a connection containing other metal nanoparticles as a component, the connection formed between the bump and another electrode.
(14) The semiconductor device according to (13) described above, in which
   the connection is formed by sintering the other metal nanoparticles that are applied.
(15) The semiconductor device according to (13) or (14) described above, in which
   the metal nanoparticles and the other metal nanoparticles contain the same type of element.
(16) The semiconductor device according to (13) or (14) described above, in which
   the metal nanoparticles and the other metal nanoparticles contain different types of elements.
(17) The semiconductor device according to any one of (13) to (16) described above, in which
   the electrode is an electrode of a semiconductor element,
   the another electrode is an electrode of a wiring board,
   the semiconductor device provided with the semiconductor element and the wiring board.
(18) A method of manufacturing a semiconductor device including:
   forming a bump by applying first metal nanoparticles onto an electrode and baking the first metal nanoparticles; and
   applying second metal nanoparticles onto at least one of the bump or another electrode, aligning the electrode with the another electrode, and baking to connect.
(19) The method of manufacturing a semiconductor device according to (18) described above, in which
   the forming the bump includes repeatedly applying and baking the first metal nanoparticles.

### REFERENCE SIGNS LIST

- 100: Semiconductor element
- 110: Electrode
- 120: Bump
- 121: First metal nanoparticle
- 200: Wiring board
- 210: Electrode
- 220: Bump
- 310: Sintered body
- 311, 312: Second metal nanoparticle

## Claims

1. A semiconductor device comprising:
an electrode; and
a bump containing metal nanoparticles as a component, the bump formed on the electrode.

2. The semiconductor device according to claim 1, wherein
the electrode is an electrode of a semiconductor element.

3. The semiconductor device according to claim 1, wherein
the electrode is an electrode of a wiring board.

4. The semiconductor device according to claim 1, wherein
the bump is formed by sintering the metal nanoparticles that are applied.

5. The semiconductor device according to claim 4, wherein
the bump includes a plurality of layers formed by repeatedly applying and sintering the metal nanoparticles a plurality of times.

6. The semiconductor device according to claim 5, wherein
in the bump, the plurality of layers is equal in size.

7. The semiconductor device according to claim 5, wherein
in the bump, adjacent layers out of the plurality of layers have different sizes.

8. The semiconductor device according to claim 7, wherein
the bump has a barrel shape as an entire shape including the plurality of layers.

9. The semiconductor device according to claim 7, wherein
the bump has a drum shape as an entire shape including the plurality of layers.

10. The semiconductor device according to claim 1, wherein
the bump contains at least one type of element of gold, silver, copper, or palladium as the metal nanoparticles.

11. The semiconductor device according to claim 1, wherein
the bump is a mixture of metal microparticles containing at least one type of element of gold, silver, copper, or palladium and the metal nanoparticles.

12. The semiconductor device according to claim 1, wherein
the bump includes a plurality of bumps having different sizes.

13. The semiconductor device according to claim 1, further comprising:
a connection containing other metal nanoparticles as a component, the connection formed between the bump and another electrode.

14. The semiconductor device according to claim 13, wherein
the connection is formed by sintering the other metal nanoparticles that are applied.

15. The semiconductor device according to claim 13, wherein
the metal nanoparticles and the other metal nanoparticles contain the same type of element.

16. The semiconductor device according to claim 13, wherein
the metal nanoparticles and the other metal nanoparticles contain different types of elements.

17. The semiconductor device according to claim 13, wherein
the electrode is an electrode of a semiconductor element,
the another electrode is an electrode of a wiring board,
the semiconductor device provided with the semiconductor element and the wiring board.

18. A method of manufacturing a semiconductor device comprising:
forming a bump by applying first metal nanoparticles onto an electrode and baking the first metal nanoparticles; and
applying second metal nanoparticles onto at least one of the bump or another electrode, aligning the electrode with the another electrode, and baking to connect.

19. The method of manufacturing a semiconductor device according to claim 18, wherein
the forming the bump includes repeatedly applying and baking the first metal nanoparticles.
